# EUROPÄISCHE PATENTSCHRIFT

(11) **EP 2 494 332 B1**
(45) Veröffentlichungstag und Bekanntmachung des Hinweises auf die Patenterteilung: **22.08.2018**
(21) Anmeldenummer: 10752736.8
(22) Anmeldetag: 14.09.2010
(51) Int. Cl.: G01N 21/03, G01N 21/3577, B01L 3/00, B81C 1/00, G01N 21/05

(54) **MESSZELLE ZUR INFRAROT-ANALYSE VON FLUIDEN, MESSSYSTEM MIT EINER SOLCHEN MESSZELLE UND VERFAHREN ZUR HERSTELLUNG EINER SOLCHEN MESSZELLE**
MEASUREMENT CELL FOR INFRARED ANALYSIS OF FLUIDS, MEASUREMENT SYSTEM USING SAID CELL, AND METHOD OF MANUFACTURING SAID CELL
CELLULE DE MESURE POUR L'ANALYSE INFRAROUGE D'UN FLUIDE, SYSTEME COMPORTANT LADITE CELLULE ET PROCEDE DE FABRICATION DE LADITE CELLULE

(30) Priorität: 27.10.2009 DE 102009051853
(43) Veröffentlichungstag der Anmeldung: 05.09.2012
(73) Patentinhaber: Hydac Electronic GmbH, 66128 Saarbrücken (DE)
(72) Erfinder: GAMEL, Frédéric, Julien, F-57800 Betting-lés-Saint-Avold (FR); BRODE, Wolfgang, Kurt, 07629 Hermsdorf (DE); MANNEBACH, Horst, 56294 Münsternmaifeld (DE); HEROLD, Frank, 66129 Saarbrücken (DE); KÄPPLINGER, Indira, 07745 Jena (DE)
(74) Vertreter: Crazzolara, Helmut
(86) Internationale Anmeldenummer: PCT/EP2010/005629
(87) Internationale Veröffentlichungsnummer: WO 2011/054412

(56) Entgegenhaltungen:
- DE-A1- 4 137 060
- DE-A1- 4 412 012
- BRUSBERG L ET AL: "Thin glass based packaging technologies for optoelectronic modules", ELECTRONIC COMPONENTS AND TECHNOLOGY CONFERENCE, 2009. ECTC 2009. 59TH, IEEE, PISCATAWAY, NJ, USA, 25. Mai 2009 (2009-05-25), Seiten 207-212, XP031474920, ISBN: 978-1-4244-4475-5
- BEMBNOWICZ P ET AL: "Integration of transparent glass window with LTCC technology for muTAS application", JOURNAL OF THE EUROPEAN CERAMIC SOCIETY, ELSEVIER SCIENCE PUBLISHERS, BARKING, ESSEX, GB, Bd. 30, Nr. 3, 4. Oktober 2009 (2009-10-04), Seiten 743-749, XP026764313, ISSN: 0955-2219, DOI: DOI:10.1016/J.JEURCERAMSOC.2009.08.025 [gefunden am 2009-10-04]
- MÜLLN T ET AL: "Optical-fluidic Sensors in LTCCtechnology", PHOTONICS AND MICROSYSTEMS, 2007 INTERNATIONAL STUDENTS AND YOUNG SCIENTISTS WORKSHOP ON, IEEE, PISCATAWAY, NJ, USA, 8. Juli 2007 (2007-07-08), Seiten 54-57, XP031283370, ISBN: 978-1-4244-1313-3
- FISCHER M ET AL: "Silicon on ceramics a new concept for micro-nano-integration on wafer level", NANOTECHNOLOGY 2008: TECHNICAL PROCEEDINGS OF THE 2008 NSTI NANOTECHNOLOGY CONFERENCE AND TRADE SHOW, BOSTON, JUNE 1 - 5, 2008; NSTI NANOTECH, CRC PRESS, US, Bd. 3, 1. Juni 2008 (2008-06-01), Seiten 157-160, XP009142033, ISBN: 978-1-4200-8505-1
- FISCHER M ET AL: "Silicon on ceramics - a new integration concept for silicon devices to LTCC", JOURNAL OF MICROELECTRONICS AND ELECTRONIC PACKAGING, IMAPS, WASHINGTON, Bd. 6, Nr. 1, 1. Januar 2009 (2009-01-01), Seiten 1-5, XP009141983, ISSN: 1551-4897

## Beschreibung

Die Erfindung betrifft eine Messzelle zur Infrarot-Analyse von Fluiden, ein Messsystem mit einer solchen Messzelle sowie ein Verfahren zur Herstellung einer solchen Messzelle.

Eine derartige Messzelle kann beispielsweise für die Analyse von Ölen eingesetzt, die in technischen Anlagen zum Übertragen von Drücken, zum Schmieren und/oder zum Kühlen eingesetzt werden. Das Öl unterliegt im Betrieb einer Alterung und/oder Verunreinigung, und für die Betriebssicherheit der Anlage ist es wesentlich, zeitnah den Qualitätszustand des Öls überprüfen zu können. Hierzu kann die wellenlängenabhängige Transmission des Öls gemessen werden, oder es können die Absorptionsbanden insbesondere im Infrarotbereich gemessen werden, und daraus Rückschlüsse auf die Qualität des Öls gezogen werden.

Reflexionsspektrometer mit derartigen Messzellen sind beispielsweise aus der DE 103 21 472 A1, der DE 197 31 241 C2 oder der EP 0 488 947 A1 bekannt. Transmissionsspektrometer sind beispielsweise aus der DE 10 2004 008 685 A1 und der GB 2 341 925 A bekannt.

Die DE 41 37 060 C2 zeigt eine Mikroküvette für die Infrarotspektroskopie.

Die US 2002/0063330 A1 zeigt eine Hitzesenke sowie ein Verfahren zur Herstellung einer solchen Hitzesenke.

Die DE 102 44 786 A1 sowie die AT 500 075 B1 zeigen ein Verfahren zum Verbinden von Wafern. Die DE 103 29 866 A1 zeigt den Einsatz des Waferbondens für ein piezoelektrisches Substrat mit Temperaturkompensation und Verfahren zur Herstellung eines Oberflächenwellenbauelements.

Die DE 199 09 692 C1 zeigt eine Durchflussmesszelle zur Untersuchung einer schnell ablaufenden chemischen Reaktion.

Die DE 101 04 957 A1 zeigt ein Verfahren zur Herstellung einer dreidimensionalen Mikrodurchflusszelle.

Aus L. Brusberg u.a.: "Thin Glass Based Packaging Technologies for Optoelectronic Modules", Electronic Components and Technology Conference, 2009, ECTC 2009, 59th IEEE, Piscataway, NJ, USA, 25. Mai 2009, S. 207-212 sind auf dünnem Glas basierte Packungstechnologien für optoelektronische Module bekannt.

Aus der DE 44 12 012 A1 ist eine Messküvette eines Gassensors bekannt, bei der zwei planparallele Platten mittels eines ringförmig ausgebildeten Abstandshalters in einem exakt definierten Abstand gehalten sind.

Aus T. Mülln: "Optical-fluidic Sensors in LTCC-Technology", Photonics and Microsystems, 2007, International Students and Young Scientists Workshop, IEEE, Piscataway, NJ, USA, 8. Juli 2007, Seiten 54-57 sind in LTCC-Technologie hergestellte opto-fluidische Sensoren bekannt.

Aus M. Fischer u.a.: "Silicon on Ceramics - A New Concept for Micro-Nano-Integration on Wafer Level", Nanotechnology 2008, Technical proceedings of the 2008 NSTI Nanotechnology Conference and Trade Show, Boston, 1. bis 5. Juni 2008, NSTI Nanotech, CRC Press, US, Band 3, 1. Juni 2008, Seiten 157-160 und aus M. Fischer u.a.: "Silicon on Ceramics - A New Integration Concept for Silicon Devices to LTCC", Journal of Microelectronics and Electronic Packaging, IMAPS, Washington, Band 6, Nr. 1, 1. Januar 2009, Seiten 1-5 sind Aufbautechniken bekannt, bei denen dünne Siliziumscheiben mit LTCC-Keramiksubstraten verbunden werden.

Aus P. Bembnowicz und L. J. Golonka: "Integration of transparant glass window with LTCC technology for microTAS application", Journal of the European Ceramic Society, Elsevier Science Publishers, Barking, Essex, GB, Band 30, Nr. 3, 4. Oktober 2009, Seiten 743-749 ist eine mikrofluidische Kammer bekannt, die durch Einbetten von Glasplatten in einen Stapel von LTCC-Schichten hergestellt ist.

Der Erfindung liegt die Aufgabe zugrunde, eine Messzelle bereitzustellen, die verbesserte Gebrauchseigenschaften aufweist, sowie ein zugehöriges Messsystem und ein zugehöriges Herstellverfahren. In einer Ausführungsart soll die Messzelle und der Sensor und Emitter auch für hohe Betriebsdrücke einsetzbar sein und dabei eine hohe Betriebszuverlässigkeit aufweisen.

Diese Aufgabe ist durch die im Anspruch 1 bestimmte Messzelle sowie durch das im nebengeordneten Anspruch bestimmte Messsystem und das im nebengeordneten Anspruch bestimmte Herstellverfahren gelöst.

Besondere Ausführungsarten der Erfindung sind in den Unteransprüchen bestimmt.

In einer Ausführungsart ist die Aufgabe gelöst durch eine Messzelle zur Infrarot-Analyse von Fluiden, insbesondere durch eine Messzelle mit einem zulässigen Betriebsdruck von mehr als 20 bar und vorzugsweise mehr als 50 bar, mit einem Strömungskanal für das Fluid, der zwischen einem ersten und einem zweiten, jeweils mindestens abschnittsweise für Infrarotstrahlung transparenten Element gebildet ist, wobei die Infrarotstrahlung über das erste Element in den Strömungskanal einstrahlbar ist und über das zweite Element aus dem Strömungskanal austreten kann, und wobei die beiden Elemente durch eine dazwischen angeordnete Verbindungsschicht aus einem glashaltigen Werkstoff, insbesondere einem gesinterten glaskeramischen Werkstoff, fluiddicht und mechanisch hochfest miteinander verbunden sind.

Vorteilhaft ist dabei, dass durch die Verbindungsschicht auch vergleichsweise dicke Elemente, wie sie für den Hochdruckeinsatz erforderlich sind, dauerhaft zuverlässig miteinander verbunden werden können, insbesondere dass die Verbindung trotz der Steifigkeit der im Hinblick auf den Hochdruckeinsatz vergleichsweise dicken Elemente ohne Lunkerstellen herstellbar ist. Im noch nicht gesinterten Zustand kann der Werkstoff der Verbindungsschicht durch entsprechende Druckausübung derart in Anlage an die Oberflächen der beiden Elemente gebracht werden, dass dadurch eine eventuell vorhandene Topographie oder Welligkeit der Oberflächen der beiden Elemente ausgeglichen wird. Dies ist insbesondere von Vorteil, wenn die Messzellen im Nutzen hergestellt werden, d. h. beispielsweise für die Elemente Platten oder Scheiben verwendet werden, auf denen gleichzeitig eine Vielzahl der Elemente und damit eine Vielzahl von Messzellen realisiert werden.

Beispielsweise können die Elemente im Nutzen aus einem Siliziumwafer mit einer Dicke von mehr als 1 mm, insbesondere mehr als 1,5 mm und vorzugsweise mehr als 2 mm, gebildet sein, und die Verbindungsschicht hat im gesinterten Zustand eine Dicke von mehr als 50 *µ*m und weniger als 500 *µ*m, insbesondere mehr als 100 *µ*m und weniger als 300 *µ*m und vorzugsweise mehr als 120 *µ*m und weniger als 200 *µ*m. Der Strömungskanal für das Fluid kann ein Mikrofluidkanal sein mit einer Länge von mehr als 3 mm, insbesondere mehr als 6 mm und vorzugsweise mehr als 9 mm, und mit einer Breite von weniger als 10 mm, insbesondere weniger als 8 mm und vorzugsweise weniger als 6 mm. In dem Strömungskanal können ein oder mehrere Abstandshalter angeordnet sein, durch die auch unter dem Hochdruckeinfluss die Höhe des Strömungskanals auf einem vorgebbaren Wert gehalten ist.
Die Abstandshalter können beispielsweise durch längs der Strömungsrichtung verlaufenden Stege gebildet sein. Die Abstandshalter und/oder die Geometrie des Strömungskanals können mindestens abschnittsweise durch eines der Elemente und/oder durch die Verbindungsschicht gebildet sein.

In einer Ausführungsart ist die Verbindungsschicht strukturiert auf eines der Elemente aufgebracht oder zwischen die beiden Elemente eingebracht. Durch die Strukturierung der Verbindungsschicht kann beispielsweise der Strömungskanal definiert sein, insbesondere können die beiden den Strömungskanal begrenzenden Elemente grundsätzlich auch unstrukturiert sein. Alternativ oder ergänzend können auch die beiden Elemente mindestens abschnittsweise eine den Strömungskanal definierende Struktur aufweisen, die beispielsweise durch Anätzen der Oberfläche hergestellt ist. Grundsätzlich kann die Verbindungsschicht durch alle beispielsweise aus der Dickschichttechnik bekannten Verfahren aufgebracht werden.

In einer Ausführungsart ist die Verbindungsschicht in Form eines Bandes, eines Tapes oder einer Membran auf eines der Elemente auflaminiert oder zwischen die beiden Elemente laminiert. Beispielsweise kann die Verbindungsschicht in Membranform auf einem die ersten Elemente einer Vielzahl von Messzellen bildenden Wafer aufgelegt werden, und ein die zweiten Elemente der Vielzahl von Messzellen bildender Wafer kann auf die Verbindungsschicht gelegt werden und anschließend der Verbund miteinander verpresst und anschließend gesintert werden.

In einer Ausführungsart weist die Verbindungsschicht Austrittskanäle für den Austritt organischer Bestandteile aus der Verbindungsschicht in einem dem Sintern vorangehenden Prozess auf. Die Austrittskanäle können durch eine gitterförmige Struktur der Verbindungsschicht gebildet sein. Das Vorsehen derartiger Austrittskanäle ist insbesondere beider Herstellung der Messzellen im Nutzen vorteilhaft, weil in diesem Fall die beim Temperaturbehandeln flüchtigen organischen Bestandteile lateral austreten können.

In einer Ausführungsart ist die Verbindungsschicht aus einer vorzugsweise Plastifikatoren aufweisenden Low Temperature Cofired Ceramic gebildet. Durch die Plastifikatoren ist ein Laminieren der Verbindungsschicht möglich. Im noch nicht gesinterten Zustand ist die Verbindungsschicht biegsam. Bestandteile der Verbindungsschicht in diesem Zustand können Glas, insbesondere Borosilikatglas, Borofloatglas und/oder Quarzglas, Keramik, beispielsweise Al2O3, und organische Bestandteile sein, die sich beim Aushärten verflüchtigen. Die Mischung dieser Bestandteile sichert die Anpassung des thermischen Ausdehnungskoeffizienten im Temperaturbereich von -50 bis +850°C an den thermischen Ausdehnungskoeffizienten der Elemente der Messzelle, insbesondere an den thermischen Ausdehnungskoeffizienten von Silizium.

In einer Ausführungsart weist die Verbindungsschicht in einem Temperaturbereich zwischen 0 und 200°C, insbesondere zwischen 0 und 400°C und vorzugsweise zwischen 0 und 600°C, einen linearen thermischen Ausdehnungskoeffizienten auf, der weniger als 8 ppm/K, insbesondere weniger als 5 ppm/K und vorzugsweise weniger als 0,5 ppm/K von dem linearen thermischen Ausdehnungskoeffizienten mindestens eines der Elemente, vorzugsweise beider Elemente, abweicht. Dadurch ist eine gute Anpassung des Ausdehnungskoeffizienten von Verbindungsschicht zu Element gewährleistet, so dass die thermisch induzierten Spannungen auch im gesinterten Zustand der Messzelle gering sind und damit eine hohe Betriebssicherheit gewährleistet ist.

Mindestens eines der beiden Elemente weist auf einer die Begrenzung für den Strömungskanal bildenden Fläche eine als Antireflexionsschicht und/oder Filterschicht für die Infrarotstrahlung und als Haftvermittler für die Verbindungsschicht wirkende Oberflächenstruktur auf. Dadurch kann die Transmissionsfähigkeit der Messzelle für Infrarotstrahlung signifikant erhöht werden, wodurch sich ein hoher Signalpegel für die Auswertung des Sensorsignals ergibt. Weiterhin kann dadurch auch ein optischer Filter in die Messzelle integriert werden, mittels dem die Absorptionsbanden des zu untersuchenden Fluids ermittelbar sind. Außerdem kann dadurch die Haftkraft der Verbindungsschicht erhöht werden, was insbesondere im Hochdruckbetrieb vorteilhaft ist. Die Oberflächenstruktur kann durch eine Nanostruktur an der Oberfläche gebildet sein.

Die Oberflächenstruktur weist eine Vielzahl von Nadeln auf mit einer Dichte von mehr als 10.000 Nadeln je mm², insbesondere mehr als 100.000 Nadeln je mm² und vorzugsweise mehr als 500.000 Nadeln je mm². Derartige nadelförmige Elemente können beispielsweise in einkristallinem Silicium durch selbstmaskiertes Trockenätzen hergestellt werden. Die dadurch hergestellte Oberflächenstruktur wird nach ihrem optischen Erscheinungsbild auch als "black silicon" bezeichnet.

In einer Ausführungsart weisen die Nadeln eine Länge von mehr als 0,3 und weniger als 30 *µ*m aufweisen, insbesondere mehr als 0,5 und weniger als 15 *µ*m, und vorzugsweise mehr als 0,8 und weniger als 8 *µ*m auf. Untersuchungen haben ergeben, dass bei einer derartigen Nadellänge ein besonders günstiges Antireflexionsverhalten für Infrarotstrahlung und/oder eine hohe Haftvermittlung zur Verbindungsschicht erzielbar ist.

Das Element weist die Oberflächenstruktur auch im Bereich der Verbindungsschicht auf. Dabei ist vorteilhaft, dass die Oberflächenstruktur alternativ oder ergänzend zu ihrer Wirkung als Antireflexionsschicht auch als Haftvermittler für die Verbindung von Element und Verbindungsschicht dient. Insbesondere können die Nadeln in das Gefüge der Verbindungsschicht eindringen und durch das hohe Oberflächen: VolumenVerhältnis der Nadeln entsteht dadurch eine großflächige Verbindungsschicht.

In einem Ausführungsbeispiel sind die beiden Elemente aus einkristallinem Silicium gebildet. Dieses weist einen ausreichend hohen Transmissionskoeffizienten für Infrarotstrahlung und außerdem ausgezeichnete mechanische Eigenschaften auf. Außerdem können die Elemente aus einkristallinem Silicium mit bekannten Strukturierungsverfahren aus der Halbleitertechnologie, einschließlich trocken- und nasschemischen Ätzverfahren, in nahezu beliebiger Weise mit hoher Präzision strukturiert werden, um Strömungskanäle zu definieren.

In einer Ausführungsart weist mindestens eines der beiden Elemente eine Dicke von mehr als 1 mm auf, insbesondere mehr als 1,5 mm und vorzugsweise mehr als 2 mm. Mit derart dicken Elementen, insbesondere in Verbindung mit dem Werkstoff einkristallinem Silicium lassen sich mechanische hochfeste und damit auch für den Hochdruckeinsatz geeignete Messzellen herstellen. Die durch die Dicke der Verbindungsschicht bestimmte Höhe des Strömungskanals kann dabei zwischen 50 und 500 *µ*m betragen, insbesondere mehr als 80 *µ*m und weniger als 400 *µ*m und vorzugsweise mehr als 100 *µ*m und weniger als 300 *µ*m.

Die Erfindung betrifft auch den Aufbau eines Messsystems für die Infrarot-Analyse von Fluiden mit einer Messzelle wie vorstehend beschrieben sowie einem Emitter und einem Sensor. Das Messsystem weist einen Emitter für die Infrarotstrahlung, beispielsweise einen breitbandig-emittierenden Heizstrahler und/oder eine vergleichsweise schmalbandig-emittierende Infrarot-Leuchtdiode, und einen Empfänger für die Infrarotstrahlung auf. Emitter und Empfänger sind vorzugsweise auf einander gegenüberliegenden Seiten der Messzelle angeordnet. Der Empfänger kann in einer Baueinheit mehrere Detektorelemente aufweisen, mittels denen die Intensität der Strahlung in verschiedenen Wellenlängenbereichen gemessen werden kann. Hierzu kann der Empfänger mehrere Eintrittsfenster aufweisen, über die jeweils Strahlung auf eines der Detektorelemente auftrifft. Die Fenster und/oder die Detektorelemente können eine Filterung bewirken.

Ebenfalls können auch mehrere Emitter mit einer schmalbandigen Emission angeordnet werden.

In einer Ausführungsart weist das Messsystem ein Einrichtungselement mit einer Aufnahmeöffnung für die Messzelle auf. Die Messzelle kann dabei in die Aufnahmeöffnung eingesetzt sein, insbesondere kann die Aufnahmeöffnung hinsichtlich ihrer Kontur mindestens abschnittsweise an die Außenkontur der Messzelle, die beispielsweise polygonal und insbesondere viereckig sein kann, angepasst sein. Das Einrichtungselement weist eine Eintrittsöffnung und eine Austrittsöffnung für das Fluid auf. Über die Eintrittsöffnung kann das Fluid in den Strömungskanal der Messzelle eintreten, und über die Austrittsöffnung kann das Fluid aus dem Strömungskanal der Messzelle austreten.

Die Erfindung betrifft auch ein Verfahren zum Herstellen einer Messzelle wie vorstehend beschrieben. Die Verbindungsschicht aus dem glaskeramischen Werkstoff kann dabei im noch nicht gesinterten Zustand, beispielsweise in Form eines Bandes oder einer Membran, zwischen den beiden Elementen angeordnet werden. Die Verbindungsschicht liegt dabei als Grünling vor. Die Verbindungsschicht kann Justagemarkierungen oder Öffnungen aufweisen, mittels denen die Verbindungsschicht auf den Träger der Elemente justiert werden kann. Die Verbindungsschicht besteht in Form einer ungesinterten Folie und kann aus einem Gemisch von Borosilikatglas, Quarzglas und Aluminiumoxyd sowie organischen Lösungsmitteln hergestellt sein.

Die Verbindungsschicht wird als Grünling beispielsweise mit einer Dicke von 300 *µ*m unter einem Druck von 250 bar und einer Temperatur von 70 °C zwischen die beiden die Elemente bildenden Scheiben laminiert.

Durch die im Grünling eingebrachten Plastifikatoren fließt die Verbindungsschicht unter dieser Belastung und gleicht alle Abstandstoleranzen zwischen den beiden Elementen aus, so dass über die gesamte Scheibenoberfläche die Verbindungsschicht in Anlage an den Elementen ist.

Die Elemente sind auf ihrer der Verbindungsschicht zugewandten Oberfläche nanostrukturiert, beispielsweise unter Bildung von Nadeln. Die Nadeln dringen in das Gefüge der Verbindungsschicht ein. Anschließend erfolgt Sinter-Prozess unter Druck- und Temperatureinwirkung. Bei einer Temperatur ab etwa 650 °C verbinden sich die Glasfritten sowohl mit allen Bestandteilen des keramischen Grünlings als auch mit den Nadeln der die Elemente bildenden Scheiben. Diese Nadeln liegen in einer Nanostruktur vor, da insbesondere ihre lateralen Abmessungen sehr klein sind. Durch die Druckbeaufschlagung im Sinterprozess wird eine laterale Schrumpfung der Verbindungsschicht im Wesentlichen verhindert. Die Schrumpfung der Verbindungsschicht senkrecht zur Oberfläche der die Elemente bildenden Scheiben kann ca. 50 % betragen.

Weitere Vorteile, Merkmale und Einzelheiten der Erfindung ergeben sich aus den Unteransprüchen und der nachfolgenden Beschreibung, in der unter Bezugnahme auf die Zeichnungen mehrere Ausführungsbeispiele im Einzelnen beschrieben sind. Dabei können die in den Ansprüchen und in der Beschreibung erwähnten Merkmale jeweils einzeln für sich oder in beliebiger Kombination erfindungswesentlich sein.
Fig. 1 zeigt eine perspektivische Ansicht eines Ausführungsbeispiels einer erfindungsgemäßen Messzelle,
Fig. 2 zeigt einen Schnitt durch ein Messsystem für die Infrarot-Analyse von Fluiden,
Fig. 3 zeigt eine perspektivische Ansicht des Einrichtungselements,
Fig. 4 bis 7 zeigen das Transmissionsverhalten von insgesamt fünf Fluidproben bei vier unterschiedlichen Wellenlängen,
Fig. 8 bis 10 zeigen verschiedene Stadien des Verfahrens zur Herstellung einer Messzelle.

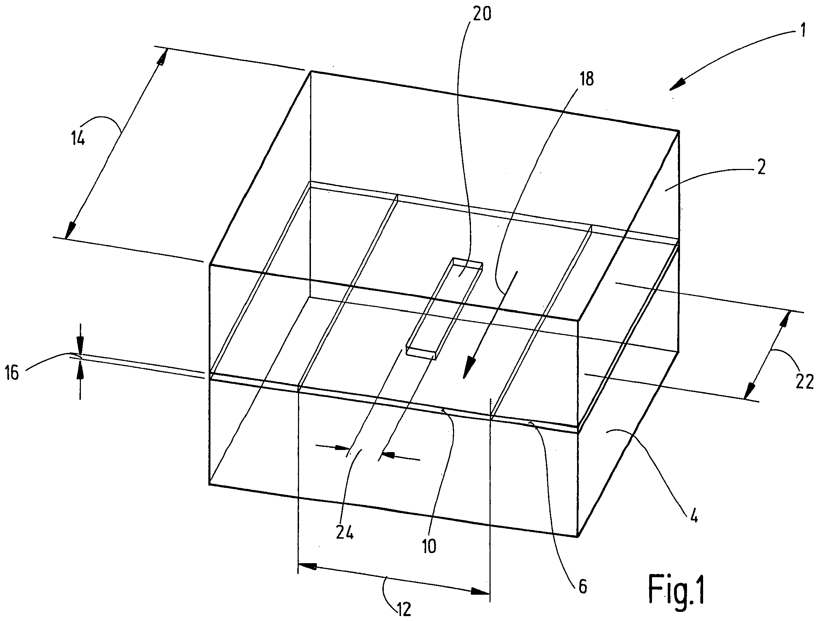

Die Fig. 1 zeigt eine perspektivische Ansicht eines Ausführungsbeispiels einer erfindungsgemäßen Messzelle 1 zur Infrarot-Analyse von Fluiden für den Hochdruckbetrieb. Der Strömungskanal 10 für das Fluid weist im Ausführungsbeispiel eine Breite 12 von 5 mm, eine Länge 14 von 9,5 und eine Höhe 16 von 0,2 mm auf. Die Strömungsrichtung ist durch den Pfeil 18 angegeben. In Strömungsrichtung 18 erstreckt sich im Strömungskanal 10 mittig in Bezug auf die Breite 12 ein Abstandshalter 20, dessen Länge 22 etwa 50 % der Länge 14 des Strömungskanals 10 beträgt, im Ausführungsbeispiel etwa 4,5 mm, und dessen Breite 24 weniger als 20 % der Breite 12 des Strömungskanals 10 beträgt, im Ausführungsbeispiel 0,8 mm. Durch den Abstandshalter 20 ist zum einen die Höhe 16 auch im mittleren Bereich des Strömungskanals 10 stabilisiert und darüber hinaus kann der stegförmig ausgebildete Abstandshalter 20 auch zur Verbesserung der laminaren Strömung im Strömungskanal 10 dienen.

Der Strömungskanal 10 ist zwischen einem ersten Element 2 und einem zweiten Element 4 gebildet, die beide jeweils mindestens abschnittsweise für Infrarotstrahlung transparent sind, und aus einkristallinem Silicium bestehen können. Über das erste Element 2 ist Infrarotstrahlung in dem Strömungskanal 10 einstrahlbar und über das zweite Element 4 kann die Infrarotstrahlung aus dem Strömungskanal austreten. Die beiden Elemente 2, 4 sind durch eine dazwischen angeordnete Verbindungsschicht 6 aus einem glashaltigen Werkstoff, insbesondere aus einem gesinterten glaskeramischen Werkstoff, fluiddicht und mechanisch hochfest miteinander verbunden.

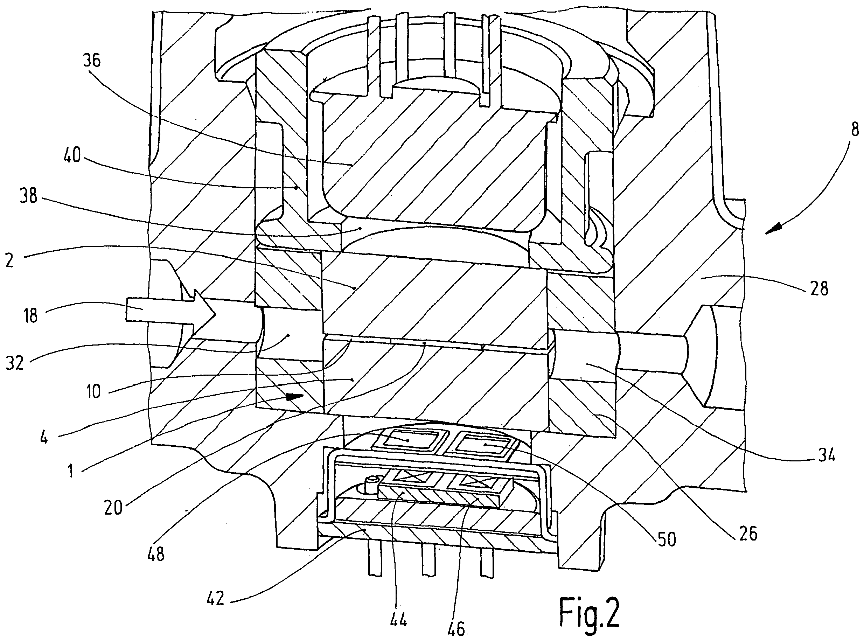

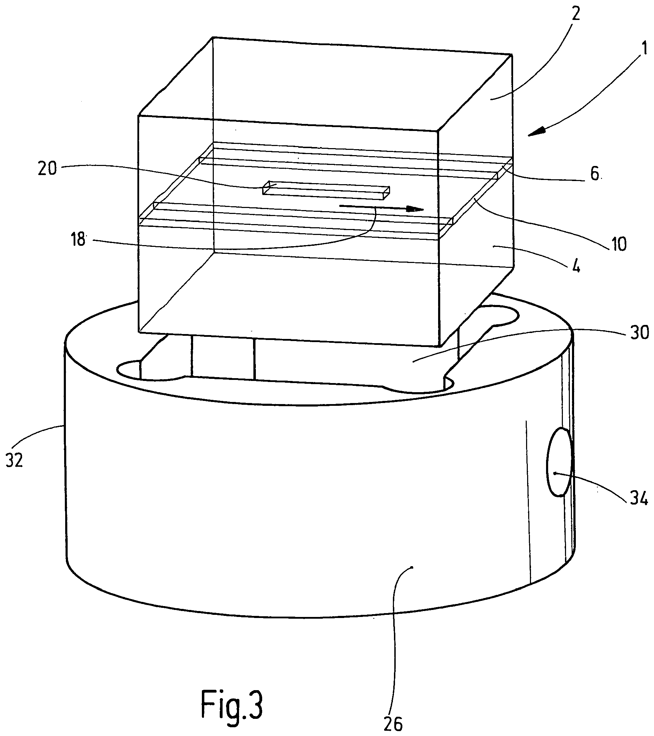

Die Fig. 2 zeigt einen Schnitt durch ein Messsystem 8 für die Infrarot-Analyse von Fluiden mit einer Messzelle 1 wie vorstehend beschrieben. Die Messzelle 1 ist dabei mittels eines Einrichtungselements 26 in einem Systemgehäuse 28 angeordnet. Die Fig. 3 zeigt eine perspektivische Ansicht des Einrichtungselements 26, das eine Aufnahmeöffnung 30 aufweist, in welche die Messzelle 1 eingesetzt werden kann. Die Aufnahmeöffnung 30 ist im Wesentlichen der Außenkontur der Messzelle 1 angepasst, die ihrerseits im Wesentlichen rechteckig oder im Sonderfall quadratisch ist. Die Aufnahmeöffnung 30 weist an ihren Ecken Ausbuchtungen auf, die ein Einsetzen der Messzelle 1 vereinfachen. Das Einrichtungselement 26 weist eine Eintrittsöffnung 32 und eine Austrittsöffnung 34 auf, über welche das Fluid in den Strömungskanal 10 der Messzelle 1 eintreten bzw. aus dem Strömungskanal 10 der Messzelle 1 austreten kann. Die Verbindung zwischen Einrichtungselement 26 und Messzelle 1 ist dabei fluiddicht, wobei die hierfür gegebenenfalls erforderlichen Dichtmittel wie beispielsweise Dichtringe oder dergleichen in der Fig. 2 aus Gründen der Übersichtlichkeit nicht dargestellt sind.

Das Messsystem 8 weist auf einer dem ersten Element 2 der Messzelle 1 zugeordneten Seite einen Emitter 36 für die Infrarotstrahlung auf. Bei dem Emitter 36 kann es sich beispielsweise um ein vergleichsweise breitbandigabstrahlendes Heizelement handeln, das jedenfalls im interessierenden Wellenlängenbereich von beispielsweise zwischen 2 und 6 *µ*m eine ausreichende Strahlungsintensität aufweist. Der Emitter 36 ist mittels eines eine zentrische Durchtrittsöffnung 38 aufweisenden Befestigungselements 40 an dem Systemgehäuse 28 vorzugsweise lösbar festgelegt. Der Emitter 36 strahlt dabei im Wesentlichen zentrisch auf das erste Element 2 der Messzelle 1 ein.

Auf der der Messzelle 1 gegenüberliegenden Seite ist in dem Messsystem 8 ein Empfänger 42 angeordnet, der gegenüber der Außenoberfläche des zweiten Elements 4 und vorzugsweise zentrisch in Bezug auf das zweite Element 4 und damit auf die Messzelle 1 angeordnet ist. Im dargestellten Ausführungsbeispiel weist der Empfänger 42 insgesamt vier Detektorelemente 44, 46 auf, von denen in der Fig. 2 aufgrund der Schnittdarstellung nur zwei Detektorelemente 44, 46 sichtbar sind. Auf seiner der Messzelle 1 zugewandten Oberfläche weist der Empfänger 42 insgesamt vier Fenster 48, 50 auf, die jeweils einem Detektorelement 44, 46 zugeordnet sind. Jedes der Fenster 48, 50 und/oder jedes der Detektorelemente 44, 46 kann eine Filterschicht aufweisen, so dass von dem vom Emitter 36 abgestrahlten und durch die Messzelle 1 hindurchgetretenen Infrarotspektrum jeweils nur ein schmalbandiger Bereich auf das Detektorelement 44, 46 einstrahlt.

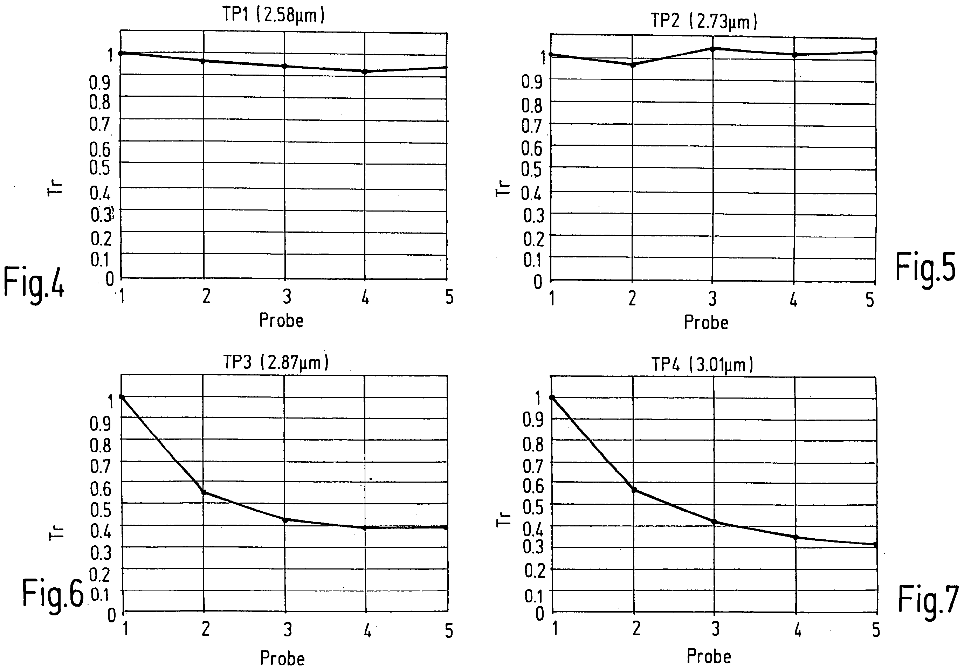

Die Figuren 4 bis 7 zeigen das relative Transmissionsverhalten Tᵣ von insgesamt fünf, hinsichtlich ihres Qualitätszustandes unterschiedlichen Fluidproben bei vier unterschiedlichen Wellenlängen zwischen 2,58 *µ*m und 3,01 *µ*m. Bei der Probe Nr. 1 handelt es sich dabei um ein frisches und noch unverbrauchtes Fluid, wobei die Alterung mit der Probenummer zunimmt. Wie sich aus den Figuren 4 und 5 ergibt, sind bei den Wellenlängen 2,58 und 2,73 *µ*m keine alterungsabhängigen Absorptionen des Fluids messbar. Demgegenüber treten gemäß den Figuren 6 und 7 bei den Wellenlängen 2,87 und 3,01 *µ*m alterungsabhängige Absorptionen auf, wobei die Wellenlängen, an denen derartige Absorptionsbanden auftreten, Rückschlüsse auf die alterungsbedingten Bestandteile in dem Fluid erlauben. Der Umstand, dass bei bestimmten Wellenlängen keine alterungsbedingte Absorption messbar ist (Fig. 4 und 5), ermöglicht es, diese Wellenlängen als Referenzbanden zu verwenden, um beispielsweise eine Vergleichsmessung durchzuführen.

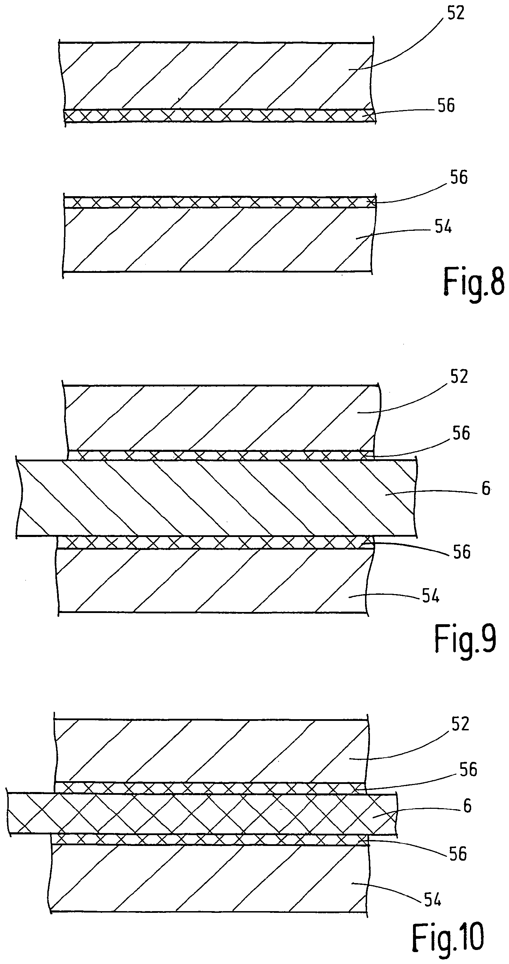

Die Figuren 8 bis 10 zeigen verschiedene Stadien des Verfahrens zur Herstellung einer Messzelle 1 wie vorstehend beschrieben. Aus Gründen der besseren Darstellbarkeit sind die Abmessungen dabei nicht maßstäblich dargestellt. Zunächst wird auf den die ersten Elemente 2 und die zweiten Elemente 4 bildenden Siliciumscheiben 52, 54 auf mindestens einer Oberfläche ganzflächig oder strukturiert eine Nanostruktur 56 aufgebracht, beispielsweise eine Oberflächenstruktur aus einer Vielzahl von Nadeln. Dieses Zwischenstadium ist in der Fig. 8 dargestellt.

Die Fig. 9 zeigt, wie zwischen die beiden Siliciumscheiben 52, 54 die Verbindungsschicht 6 mit einer Dicke von etwa 300 *µ*m laminiert wird, vorzugsweise durch Einwirken von Druck zwischen 50 und 500 bar, insbesondere zwischen 200 und 300 bar und vorzugsweise 250 bar, und Temperatur zwischen 50 und 100°, insbesondere zwischen 60 und 80° und vorzugsweise 70°. Die Verbindungsschicht 6 kann aus einem glashaltigen und insbesondere glaskeramischen Werkstoff bestehen, beispielsweise aus einer sogenannten LTCC-Keramik. Die Verbindungsschicht 6 kann in Form eines Tapes als Grünling laminiert werden. Durch die im Tape eingebrachten Plastifikatoren fließt die Verbindungsschicht 6 unter dem Laminierdruck und gleicht dadurch alle Abstandstoleranzen zwischen den Siliciumscheiben 52, 54 aus. Dabei dringt die Nadelstruktur 56 in die Oberfläche der Verbindungsschicht 6 ein.

Die Strukturierung des Tapes und/oder der Siliziumwafer sichert durch eingebrachte Kanäle den Abtransport der Organik aus dem Tape im Entbinderungsprozess. Durch die Verbindungsschicht 6, insbesondere durch deren Eigenschaften vor dem Sinterprozess, werden die Ebenheitsfehler der Elemente 2, 4 ausgeglichen, insbesondere bei der Herstellung im Nutzen.

Die Fig. 10 zeigt den Zustand nach dem Sintern, das bei einer Temperatur von mehr als 600° erfolgt, vorzugsweise mehr als 750° und beispielsweise zwischen 800 und 900°. Dabei verbinden sich die Glasbestandteile der Verbindungsschicht 6 sowohl mit allen Bestandteilen des keramikhaltigen Tapes als auch mit der Nanostruktur 56 der Siliciumscheiben 52, 54. Durch die Druckbeaufschlagung im Sinterprozess wird eine laterale Schrumpfung der Glaskeramik im Wesentlichen oder sogar vollständig unterbunden. Die Schrumpfung senkrecht zur Oberfläche der Siliciumscheiben 52, 54 beträgt ca. 50 %, so dass am Ende die Verbindungsschicht 6 in einer Dicke von etwa 150 *µ*m vorliegt.

## Patentansprüche

1. Messzelle (1) zur Infrarot-Analyse von Fluiden, insbesondere Messzelle (1) mit einem zulässigen Betriebsdruck von mehr als 20 bar und vorzugsweise mehr als 50 bar, mit einem Strömungskanal (10) für das Fluid, der zwischen einem ersten und einem zweiten, jeweils mindestens abschnittsweise für Infrarotstrahlung transparenten Element (2, 4) gebildet ist, wobei die Infrarotstrahlung über das erste Element (2) in den Strömungskanal (10) einstrahlbar ist und über das zweite Element (4) aus dem Strömungskanal (10) austreten kann, und wobei die beiden Elemente (2, 4) durch eine dazwischen angeordnete Verbindungsschicht (6) aus einem gesinterten glaskeramischen Werkstoff fluiddicht und mechanisch hochfest miteinander verbunden sind, und die Verbindungsschicht (6) als keramische Folie strukturiert ist und dadurch der Strömungskanal (10) in seiner Form definiert ist, **dadurch gekennzeichnet, dass** mindestens eines der beiden Elemente (2, 4) sowohl auf einer die Begrenzung für den Strömungskanal (10) bildenden Fläche als auch im Bereich der Verbindungsschicht (6) eine Oberflächenstruktur (56) mit einer Vielzahl von Mikronadeln mit einer Dichte von mehr als 10.000 Nadeln je mm² aufweist, dass die Oberflächenstruktur (56) in der die Begrenzung für den Strömungskanal (10) bildenden Fläche als Antireflektionsschicht und/oder als Filterschicht für die Infrarotstrahlung wirkt, und dass die Oberflächenstruktur (56) im Bereich der Verbindungsschicht (6) als Haftvermittler für die Verbindung des Elements (2, 4) mit der Verbindungsschicht (6) wirkt.

2. Messzelle (1) nach Anspruch 1, **dadurch gekennzeichnet, dass** die Verbindungsschicht (6) strukturiert auf eines der Elemente (2, 4) aufgebracht ist.

3. Messzelle (1) nach Anspruch 1 oder 2, **dadurch gekennzeichnet, dass** die Verbindungsschicht (6) Austrittskanäle für den Austritt organischer Bestandteile aus der Verbindungsschicht (6) in einem dem Sintern vorangehenden Prozess aufweist.

4. Messzelle (1) nach einem der vorgenannten Ansprüche, **dadurch gekennzeichnet, dass** die Verbindungsschicht (6) aus einer Plastifikatoren aufweisenden Low Temperature Cofired Ceramic gebildet ist.

5. Messzelle (1) nach einem der vorgenannten Ansprüche, **dadurch gekennzeichnet, dass** die gesinterte Verbindungsschicht (6) in einem Temperaturbereich zwischen 0 und 200°C, insbesondere zwischen 0 und 400°C und vorzugsweise zwischen 0 und 600°C, einen linearen thermischen Ausdehnungskoeffizienten aufweist, der weniger als 8 ppm/K, insbesondere weniger als 5 ppm/K und vorzugsweise mehr als 3 ppm/K aufweist.

6. Messzelle (1) nach einem der vorgenannten Ansprüche, **dadurch gekennzeichnet, dass** die Oberflächenstruktur (56) Mikronadeln aufweist mit einer Dichte von mehr als 100.000 Nadeln je mm² und vorzugsweise mehr als 500.000 Nadeln je mm².

7. Messzelle (1) nach einem der vorgenannten Ansprüche, **dadurch gekennzeichnet, dass** die Nadeln eine Länge von mehr als 0,3 und weniger als 30 *µ*m aufweisen, insbesondere mehr als 0,5 und weniger als 15 *µ*m, und vorzugsweise mehr als 0,8 und weniger als 8 *µ*m.

8. Messzelle (1) nach einem der vorgenannten Ansprüche, **dadurch gekennzeichnet, dass** die beiden Elemente (2, 4) aus einkristallinem Silizium gebildet sind.

9. Messzelle (1) nach einem der vorgenannten Ansprüche, **dadurch gekennzeichnet, dass** mindestens eines der beiden Elemente (2, 4) eine Dicke von mehr als 1 mm aufweist, insbesondere mehr als 1,5 mm und vorzugsweise mehr als 2 mm.

10. Messzelle (1) nach einem der vorgenannten Ansprüche, **dadurch gekennzeichnet, dass** in mindestens eines der beiden Elemente (2, 4), vorzugsweise in beide Elemente (2, 4), mikrofluidische Strukturen eingebracht sind, und dass die mikrofluidischen Strukturen vorzugsweise in einen die Elemente (2, 4) bildenden Siliziumwafer eingebracht sind.

11. Messsystem (8) für die Infrarot-Analyse von Fluiden mit einer Messzelle (1) nach einem der vorangehenden Ansprüche und mit einem Emitter (36) für die Infrarotstrahlung und einem Empfänger (42) für die Infrarotstrahlung.

12. Messsystem (8) nach Anspruch 11, **dadurch gekennzeichnet, dass** das Messsystem (8) ein Einrichtungselement (26) mit einer Aufnahmeöffnung (30) aufweist, in welche die Messzelle (1) eingesetzt ist, und dass das Einrichtungselement (26) eine Eintrittsöffnung (32) und eine Austrittsöffnung (34) für das Fluid aufweist, über welche das Fluid in den Strömungskanal (10) der Messzelle (1) eintreten bzw. aus dem Strömungskanal (10) der Messzelle (1) austreten kann.

13. Verfahren zur Herstellung einer Messzelle (1) nach einem der Ansprüche 1 bis 10, **dadurch gekennzeichnet, dass** die Verbindungsschicht (6) aus einem glaskeramischen Werkstoff im noch nicht gesinterten Zustand zwischen den beiden Elementen (2, 4) angeordnet wird und anschließend die Anordnung aus den beiden Elementen (2, 4) und der Verbindungsschicht (6) durch Temperatur und Druckeinwirkung gesintert wird und dabei eine fluiddichte und mechanisch hochfeste Verbindung hergestellt wird.

## Claims

1. Measuring cell (1) for infrared analysis of fluids, in particular measuring cell (1) with an allowable operating pressure of more than 20 bar and preferably more than 50 bar, with a flow channel (10) for the fluid, which is formed between a first and a second element (2, 4), each transparent to infrared radiation, at least in sections, wherein the infrared radiation can irradiate the flow channel (10) via the first element (2) and can emerge from the flow channel (10) via the second element (4), and wherein the two elements (2, 4) are joined so that they are impermeable to fluids and mechanically strong by a bonding layer (6) between them of a sintered glass ceramic material, and the bonding layer (6) is structured as a ceramic film and thereby the flow channel (10) is structured in its form, **characterised in that** one of the two elements (2, 4) has a surface structure (56) with a multiplicity of micro-needles with a density of more than 10,000 needles per mm², both on a surface forming the boundary for the flow channel (10) and also in the area of the bonding layer (6), that the surface structure (56) acts in the surface forming the boundary for the flow channel (10) as anti-reflection layer and/or as filter layer for the infrared radiation, and that the surface structure (56) in the area of the bonding layer (6) acts as adhesion promoter for bonding the element (2, 4) to the bonding layer (6) .

2. Measuring cell (1) according to claim 1, **characterised in that** the bonding layer (6) structure is applied to one of the elements (2, 4).

3. Measuring cell (1) according to claim 1 or 2, **characterised in that** the bonding layer (6) has outlet channels for discharging organic constituents from the bonding layer (6) in a process preceding sintering.

4. Measuring cell (1) according to one of the preceding claims, **characterised in that** the bonding layer (6) comprises low temperature cofired ceramic incorporating plasticisers.

5. Measuring cell (1) according to one of the preceding claims, **characterised in that** the sintered bonding layer (6) has a linear thermal expansion coefficient in a temperature range between 0 and 200°C, in particular between 0 and 400°C and preferably between 0 and 600°C, which is less than 8 ppm/K, in particular less than 5 ppm/K and preferably more than 3 ppm/K.

6. Measuring cell (1) according to one of the preceding claims, **characterised in that** the surface structure (56) comprises micro-needles with a density of more than 100,000 needles per mm² and preferably more than 500,000 needles per mm².

7. Measuring cell (1) according to one of the preceding claims, **characterised in that** the needles have a length of more than 0.3 and less than 30 µm, in particular more than 0.5 and less than 15 µm, and preferably more than 0.8 and less than 8 µm.

8. Measuring cell (1) according to one of the preceding claims, **characterised in that** the two elements (2, 4) are formed from single-crystal silicon.

9. Measuring cell (1) according to one of the preceding claims, **characterised in that** at least one of the two elements (2, 4) has a thickness of more than 1 mm, in particular more than 1.5 mm and preferably more than 2 mm.

10. Measuring cell (1) according to one of the preceding claims, **characterised in that** microfluid structures are introduced into at least one of the two elements (2, 4), preferably in both elements (2, 4), and that the microfluid structures are inserted in a silicon wafer forming one of the elements (2, 4).

11. Measuring system (8) for the infrared analysis of fluids with a measuring cell (1) according to one of the preceding claims and with an emitter (36) for the infrared radiation and a receiver (42) for the infrared radiation.

12. Measuring system (8) according to claim 11, **characterised in that** the measuring system (8) comprises an installation element (26) with a receiving aperture (30), into which the measuring cell (1) is inserted, and that the installation element (26) has an inlet aperture (32) and an outlet aperture (34) for the fluid, by means of which the fluid can enter the flow channel (10) of the measuring cell (1) and can leave the flow channel (10) of the measuring cell (1).

13. Method for manufacturing a measuring cell (1) according to one of the claims 1 to 10, **characterised in that** the bonding layer (6) of a glass ceramic material in the as yet unsintered state is arranged between the two elements (2, 4) and then the arrangement of the two elements (2, 4) and the bonding layer (6) is sintered under the effect of temperature and pressure and thereby a fluid-tight and mechanically high strength bond is formed.

## Revendications

1. Cellule (1) de mesure pour l'analyse infrarouge de fluides, notamment cellule (1) de mesure ayant une pression de fonctionnement admissible de plus de 20 bar et de préférence de plus de 50 bar, comprenant un conduit (10) d'écoulement du fluide, qui est formé entre un premier et un deuxième éléments (2, 4), transparents chacun, au moins par endroit, au rayonnement infrarouge, le rayonnement infrarouge pouvant entrer, par le premier élément (2), dans le conduit (10) d'écoulement et pouvant sortir du conduit (10) d'écoulement par le deuxième élément (4) et dans lequel les deux éléments (2, 4) sont reliés entre eux d'une manière étanche au fluide et très résistante mécaniquement par une couche (6) de liaison interposée entre eux, en un matériau vitrocéramique fritté et la couche (6) de liaison est structurée sous la forme d'une feuille céramique et ainsi le conduit (10) d'écoulement est défini dans sa forme,
**caractérisée en ce qu'**au moins l'un des deux éléments (2, 4) a, tant sur une surface formant la délimitation du conduit (10) d'écoulement qu'également dans la région de la couche (6) de liaison, une structure (56) de surface ayant une pluralité de micro aiguilles en une densité de plus de 10.000 aiguilles par mm², **en ce que** la structure (56) de surface, dans la surface formant la délimitation du conduit (10) d'écoulement, agit en tant que couche antiréfléchissante et/ou en tant que couche filtrante du rayonnement infrarouge et **en ce que** la structure (56) de surface agit dans la région de la couche (6) de liaison en tant qu'agent adhésif pour la liaison de l'élément (2,4) à la couche (6) de liaison.

2. Cellule (1) de mesure suivant la revendication 1, **caractérisée en ce que** la couche (6) de liaison est déposée de manière structurée sur l'un des éléments (2, 4).

3. Cellule (1) de mesure suivant la revendication 1 ou 2, **caractérisée en ce que** la couche (6) de liaison a des canaux de sortie pour la sortie de constituants organiques de la couche (6) de liaison dans une opération précédant le frittage.

4. Cellule (1) de mesure suivant l'une des revendications précédentes, **caractérisée en ce que** la couche (6) de liaison est en céramique co-cuite à basse température ayant des plastifiants.

5. Cellule (1) de mesure suivant l'une des revendications précédentes, **caractérisée en ce que** la couche (6) de liaison frittée a, dans une plage de température comprise entre 0 et 200°C, notamment entre 0 et 400°C et de préférence entre 0 et 600°C, un coefficient de dilatation thermique linéaire, qui est plus petit que 8 ppm/K, notamment plus petit que 5 ppm/K et de préférence plus grand que 3 ppm/K.

6. Cellule (1) de mesure suivant l'une des revendications précédentes, **caractérisée en ce que** la structure (56) de surface a des micro aiguilles en une densité de plus de 100.000 aiguilles par mm² et de préférence de plus de 500.000 aiguilles par mm².

7. Cellule (1) de mesure suivant l'une des revendications précédentes, **caractérisée en ce que** les aiguilles ont une longueur de plus de 0,3 et de moins de 30 µm, notamment de plus de 0,5 et de moins de 15 µm et de préférence de plus de 0,8 et de moins de 8 µm.

8. Cellule (1) de mesure suivant l'une des revendications précédentes, **caractérisée en ce que** les deux éléments (2, 4) sont en silicium monocristallin.

9. Cellule (1) de mesure suivant l'une des revendications précédentes, **caractérisée en ce qu'**au moins l'un des deux éléments (2, 4) a une épaisseur de plus de 1 mm, notamment de plus de 1,5 mm et de préférence de plus de 2 mm.

10. Cellule (1) de mesure suivant l'une des revendications précédentes, **caractérisée en ce que**, dans au moins l'un des deux éléments (2, 4), de préférence dans les deux éléments (2, 4), sont ménagées des structures microfluidiques et **en ce que** les structures microfluidiques sont ménagées de préférence dans une tranche de silicium formant les éléments (2, 4).

11. Système (8) de mesure pour l'analyse infrarouge de fluides, comprenant une cellule (1) de mesure suivant l'une des revendications précédentes et comprenant un émetteur (36) du rayonnement infrarouge et un récepteur (42) du rayonnement infrarouge.

12. Système (8) de mesure suivant la revendication 11, **caractérisé en ce que** le système (8) de mesure a un élément (26) d'équipement ayant une ouverture (30) de réception, dans laquelle la cellule (1) de mesure est insérée et **en ce que** l'élément (26) d'équipement a une ouverture (32) d'entrée et une ouverture (34) de sortie du fluide, par lesquelles le fluide peut entrer dans le conduit (10) d'écoulement de la cellule (1) de mesure ou peut sortir du conduit (10) d'écoulement de la cellule (1) de mesure.

13. Procédé de fabrication d'une cellule (1) de mesure suivant l'une des revendications 1 à 10,
**caractérisé en ce que**
on met la couche (6) de liaison en un matériau vitrocéramique, à l'état encore non fritté, entre les deux éléments (2, 4) et ensuite, on fritte le système composé des deux éléments (2, 4) et de la couche (6) de liaison par action de la température et de la pression et on produit ainsi une liaison étanche au fluide et très résistante mécaniquement.
